# EUROPEAN PATENT APPLICATION

(11) **EP 2 557 603 A2**
(43) Date of publication of application: **13.02.2013**
(21) Application number: 12004838.4
(22) Date of filing: 28.06.2012
(51) Int. Cl.: H01L 31/048, B32B 27/00

(54) **Photovoltaic module for the generation of electricity, particularly for the top surface covering of residential and industrial buildings, caravans, recreational vehicles and boats**

(30) Priority: 01.07.2011 IT AR20110010 U; 25.06.2012 IT AR20120008 U
(71) Applicant: High Facing S.P.A., 52016 Castel Focognano (IT)
(72) Inventor: Schiatti, Carlo, 52100 Arezzo (IT)
(74) Representative: Olivieri, Antonella

(57) **Abstract**

A photovoltaic module for the generation of electricity, particularly for the top surface covering of residential and industrial buildings, caravans, recreational vehicles and boats, according to the invention, comprising:
- a front sheet (2) on outer position with respect to the top surface covering (9) of a building, in a transparent material and associated with at least a first plastic copolymer layer (3),
- a photovoltaic sheet (5) interposed between the first plastic copolymer layer (3) and a second plastic copolymer layer (6), and
- a flexible sheet (7) associated to the second plastic copolymer layer (6).

## Description

The present invention relates to a photovoltaic module for the generation of electricity, particularly for the top surface covering of residential and industrial buildings, caravans, recreational vehicles and boats.

At the state of the art, there are known photovoltaic modules for the generation of electricity which are arranged to be installed on flat roofs, realized as a multilayer sheet (also called "sandwich panels") with a photovoltaic sheet consisting of a monocrystalline panel associated with one rigid supporting sheet.

However, this device, which has high energy efficiency, is not suitable for curved infill elements that have a section with a certain radius of curvature.

There are also known photovoltaic multilayer modules, which comprise an amorphous photovoltaic sheet (having a blue color cell, a green cell and a red cell) for the absorption of solar light in different wavelengths. This amorphous sheet is positioned below an external sheet, relative to the cover of the building, in polytetrafluoroethylene (PTFE).

Under the photovoltaic sheet, there is a layer of reflecting material associated with a flexible foil made of stainless steel that is glued to the top surface covering.

This type of module is very flexible but has low efficiency (the available power is less than 0.065 kWp/m²) and low productivity due to the use of amorphous silicon solar cells (which have an efficiency equal to about half of those obtainable with a monocrystalline or polycrystalline silicon). Moreover, it involves extremely high manufacturing costs due to the use of amorphous silicon cells.

Furthermore, panels made with these photovoltaic modules may often lack uniformity and may not have appropriate physical characteristics (i.e. low mechanical resistance), depending on the substrate and on the structural capacity of the buildings on which they are mounted.

In addition to this, these devices are brittle and may be subject to fracture by wheather elements to which they are normally exposed, in particular of hail, which can cause substantial damages.

Finally it may happen that, in the presence of inexperienced workers or particular environmental conditions, the modules, handled with clumsy superficiality, may fall, causing the rupture of solar cells that are particularly fragile.

The object of the present invention is to eliminate the drawbacks noted above in known types of photovoltaic module for the generation of electricity, particularly for the top surface covering of residential and industrial buildings, caravans, recreational vehicles and boats, which can ensure high efficiency and high productivity.

Within this aim, an object of the present invention is to provide a photovoltaic module for the generation of electrical energy, which is flexible and can therefore be used even on curved infill elements.

It is another objective of the present invention to realize a photovoltaic module that is economically convenient and profitable.

It is another objective of the photovoltaic module, according to the invention, to produce modules less susceptible to extreme weather than those known, especially so as to avoid breakage due to hail.

It is another objective of the invention is to limit as much as possible ruptures, due to incompetence of workers while mounting and/or assembling, thereby strengthening the structure of the module itself.

It is therefore to be expected to provide a photovoltaic module for the generation of electricity, particularly for the top surface covering of residential and industrial buildings, caravans, recreational vehicles and boats with means which are easily available commercially and by using commonly used materials, so that the device is economically competitive and easy to assemble.

This aim and these and others objectives which will become better apparent hereinafter, are achieved by a photovoltaic module for the generation of electricity, particularly for the top surface covering of residential and industrial buildings, caravans, recreational vehicles and boats, according to the invention, comprising:
- a front sheet on outer position with respect to the top surface covering of a building, in a transparent material and associated with at least a first plastic copolymer layer,
- a photovoltaic sheet interposed between said first plastic copolymer layer and a second plastic copolymer layer, and also comprising
- a flexible sheet associated to said second plastic copolymer layer.

Further characteristics and advantages of the invention will become better apparent from the following detailed description of a preferred but not exclusive embodiment of the photovoltaic module for the generation of electricity, particularly for the top surface covering of residential and industrial buildings, caravans, recreational vehicles and boats, illustrated by way of non-limiting example in the accompanying drawings, wherein:
Figure 1 represents the photovoltaic module for the generation of electricity according to the invention, in perspective view and in a position arranged to be associated with a curved top surface covering;
Figure 2 represents, in a perspective view, a portion of a first variant of the photovoltaic module;
Figure 3 represents, in a perspective view, a portion of a second variant of the photovoltaic module;
Figure 4 shows a third variant of the photovoltaic module, sectioned by a plane which is substantially normal to the plane defined by the surface covering;
Figure 5 shows a fourth variant of the photovoltaic module, sectioned by a plane which is substantially normal to the plane defined by the surface covering;
Figure 6 shows a fifth variant of the photovoltaic module, sectioned by a plane which is substantially normal to the plane defined by the surface covering;
Figure 7 shows another embodiment of the photovoltaic module which is arranged to be mounted on the top surface covering of caravans, recreational vehicles and boats, sectioned by a plane which is substantially normal to the plane defined by the surface covering;
Figure 8 represents the photovoltaic module mounted on an infill element, from a lateral elevation view.

With reference to the figures, a photovoltaic module for the generation of electricity, particularly for the top surface covering of residential and industrial buildings, caravans, recreational vehicles and boats, according to the invention is generally designated by the reference numeral 1.

One of the features of the device 1 is that it comprises:
- a front sheet 2, on outer position with respect to the top surface covering 9 of a building, in a transparent material, associated with at least a first plastic copolymer layer 3,
- a photovoltaic sheet 5, interposed between the first plastic copolymer layer 3 and a second plastic copolymer layer 6, and also comprises
- a flexible sheet 7 associated with the second plastic copolymer layer 6.

The flexible sheet 7, known per se, comprises at least one polyester film 21 coated with a top film 22' and a low film 22" in polyvinylidene fluoride (PVF).

This flexible sheet 7 acts as a barrier to moisture as well as corrosive elements and also thermally isolates the module.

The term "plastic copolymer" refers to all indicated macromolecules whose polymer chain contains monomers of two or more different types.

It can be expected a frame 14 for the connection of the device to the photovoltaic system.

Advantageously, the front layer 2 has a rusticated external surface, so as to be slip-resistant.

Preferably, the front sheet 2 is made of a material which is provided with a polymer chain that comprises ethylene tetrafluoroethylene (also known as ETFE), or from other glassy materials, i.e. glass and glass-like materials with glass-like properties.

Referring to Fig. 7, when the module 1 is mounted on the top surface covering of caravans, recreational vehicles (RV), boats and similar, the front sheet 2 preferably comprises an additional flexible sheet 7b which consists of one polyester film 21b coated with a top film 22'b and a bottom film 22"b in polyvinylidene fluoride. This flexible sheet 7b should be optically transparent.

In one of the embodiments chosen, the plastic copolymer layers 3 and 6 are provided with a macromolecule which consists of Ethylene Vinyl-Acetate (EVA).

Ethylene Vinyl Acetate is a material created in the 1990s to make products which are extremely flexible and elastic. EVA is selected by many manufacturers since it presents a very low density (compact), has great shocks absorption capacity, is hypoallergenic and has excellent mechanical properties. For this reason, EVA is capable of undergoing irreversible chemical transformation, which makes it therefore stable over time, unlike for example common thermoplastic products.

Advantageously, the first layer plastic copolymer 3 has an upper face associated with the front sheet 2 and a lower face associated with at least one protection and reinforcement layer 4.

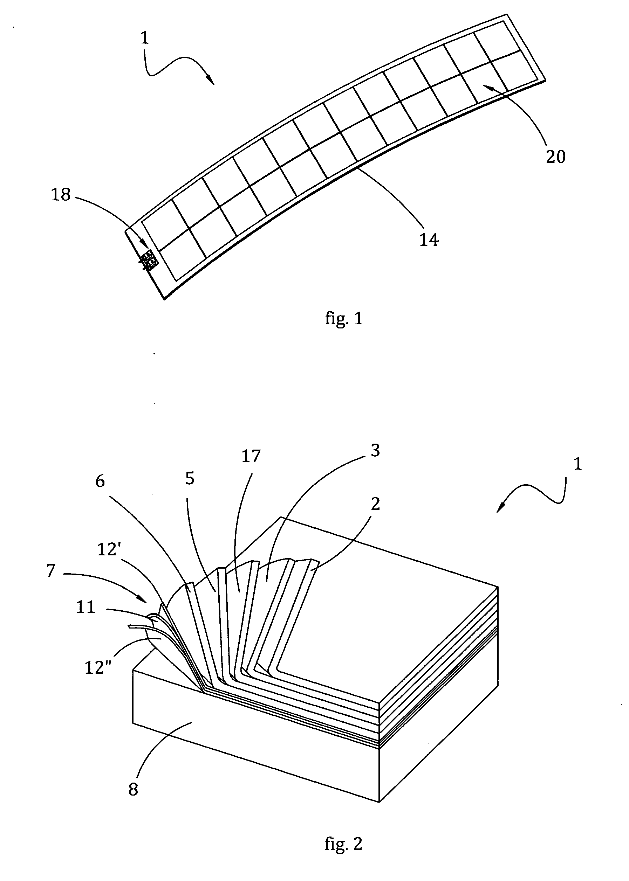

With reference to Fig. 2, there can be provided a second reinforcement layer 17, in copolymer plastic.

It is possible to provide the layer 4 with at least one additional plastic copolymer layer 10 which allows to improve the adhesion of beneath layers.

The protection and reinforcement layer 4 may also be provided with a flexible foil made of at least one polyester film 11 encapsulated between two coating films 12' and 12", optically transparent, in polyvinylidene fluoride, to offer an improved protection for the photovoltaic sheet 5 below against hail and to afford an adequate rigidity to the module.

Preferably, the protection and reinforcement layer 4 can also have a first lamina 13 in glass fiber for increasing the mechanical characteristics of the module and for improving resistance to foot traffic.

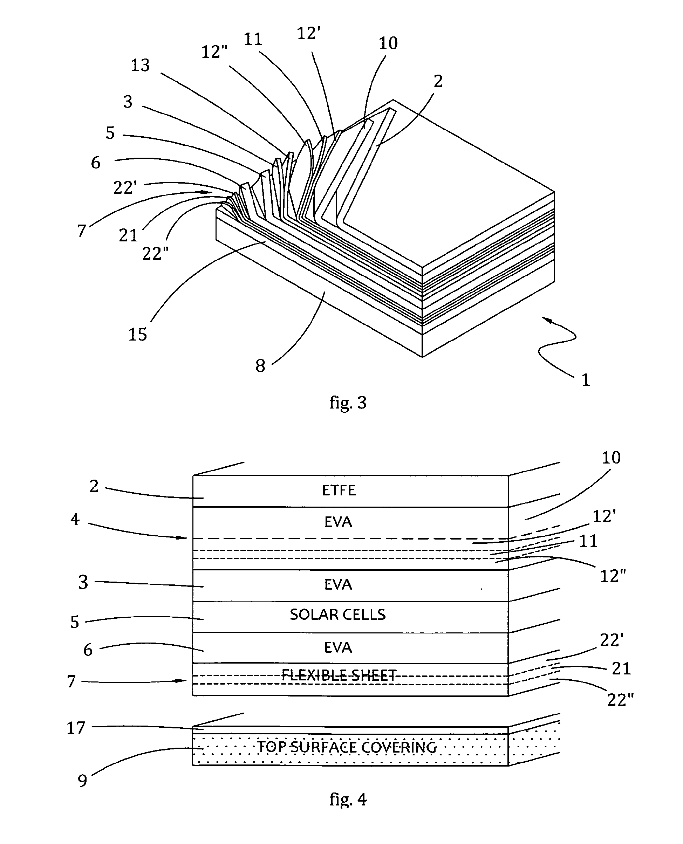

In some variants presented here (Figures 3, 5 and 6), the protection and reinforcement layer 4 at the same time has:
- the additional layer 10,
- the polyester film 11 encapsulated between the two coating films 12' and 12", and
- the first lamina in glass fiber 13.

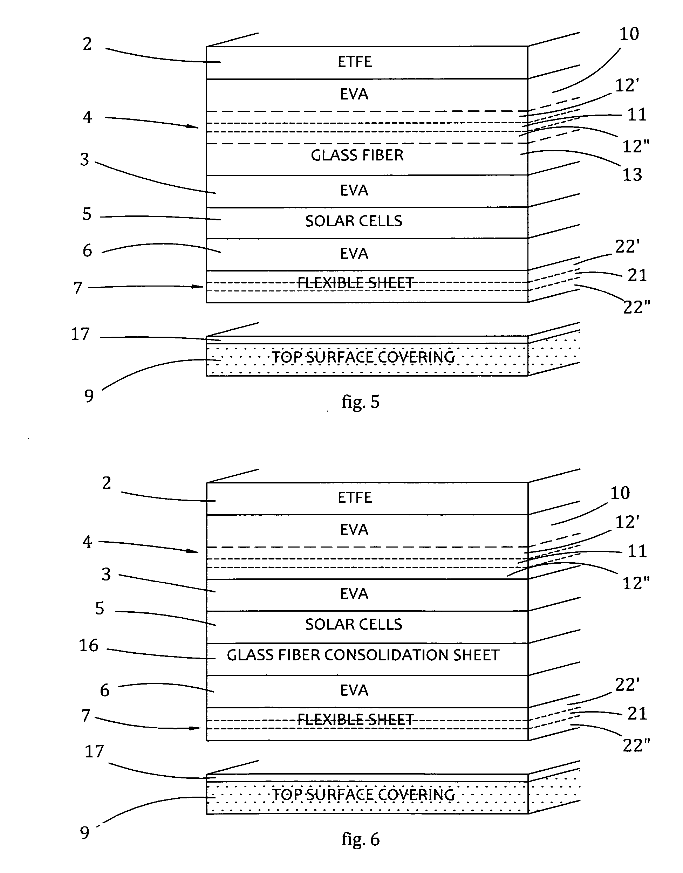

In other embodiments, it may otherwise be provided that, for example, the layer of protection and reinforcement is constituted by the polyester film 11 between the copolymer film 12' and 12", without using the lamina in glass fiber 13 (Figures 4 and 6).

The photovoltaic sheet 5 comprises a succession of solar cells 20 interconnected by means of wet copper tiebacks which are sold in the form of coils.

These cells 20 may be made of monocrystalline silicon, polycrystalline silicon, or other photosensitive material technically equivalent.

The solar cells 20 may also be of the type "CIGS", a semiconductor composite material comprising of copper, indium, gallium and selenium.

There are also provided junction boxes of the terminal blocks that collect the solar cells 20. These junction boxes, known per se, allow the exit of the terminal blocks from the connector 18.

With reference to Figure 1, the photovoltaic module 1 has two series of photovoltaic cells extending along the expansion direction of the module itself, which are connected to the connector 18 by means of a single line of junction boxes. The line of junction boxes is positioned substantially along the median axis of the module itself.

Preferably, the module 1 comprises a consolidation sheet 16 in glass fiber, which is interposed between the photovoltaic sheet 5 and the second plastic copolymer layer 6, for counteracting the possible damage caused by maneuvering the modules without proper care taken. The consolidation sheet 16 is bound at the upper surface of the of the second layer 6 (Fig. 4).

With reference to Figures 2 and 3, the photovoltaic module 1 may also include at least one sheet-like element 8 connected to the flexible sheet 7 by means of association and arranged to be bound at the top surface covering 9.

Preferably, such means of association may include an Ethylene-Vinyl Acetate layer 15 interposed between the lower surface of the sheet 7 and the upper surface of the sheet-like element 8. The layer 15 permits to bond the sheet 7 and the element 8, by means of heated fusion, into only one unbreakable element, thanks to the above mechanical properties of Ethylene-Vinyl-Acetate, in particular its shock absorption and strong resistance.

Normally the element 8 is a laminate metal alloy, which consists of aluminum and zinc (also called "aluzinc") and gives excellent mechanical characteristics to the module.

In other embodiments, the clement 8 can be made of supplementary materials such as fiberglass, glass, composite fiber-reinforced materials or be constituted by a polyester film 21' coated by films 22' and 22" in polyvinylidene fluoride, similar to what was seen for the flexible plate 7, depending on the substrate and/or to avoid problems of thermal expansion and/or for reasons of structural capacity and/or to prevent electrical discharges.

In practice, the module 1 is carried on the top surface covering of a building (or on the roof of the caravan, RV and boat) on which it must be installed, and then it is fixed to the covering 9 (that could be flat or curve-shaped) by associating the element 8 (Figures 2 and 3) or the flexible sheet 7 (Figures 4, 5 and 6).

The associating operation normally consists of spreading a layer of butyl glue 17, known per se, between the lower surface of the module 1 (that can be either the element 8 or the sheet 7) and the supporting surface of the top surface covering 9.

Afterwards, the photovoltaic module is connected to the photovoltaic system via the connector 18.

From what has been described above it is therefore evident that the invention achieves the proposed aim and objectives and, in particular, the fact is stressed that a photovoltaic module for the generation of electricity is provided, particularly for the top surface covering of residential and industrial buildings, caravans, recreational vehicles and boats, which ensures high performance and high efficiency because of the photovoltaic sheet, that comprises a monocrystalline or polycrystalline solar cells.

Another advantage of the invention is due the fact that, thanks to the flexible sheet, the photovoltaic module can be used on flat and curved top surface coverings (Fig. 8).

In particular, the use of a polyester film 11 coated with PVF, is able to provide a grade of rigidity which allows, in addition to a reasonable amount of flexibility of the module, a certain reliability and durability.

Another advantage of the invention is to allow the realization of a photovoltaic module for the production of electrical energy with low costs because of the commercial convenience of solar cells in monocrystalline or polycrystalline.

Another advantage of the photovoltaic module, according to the invention, is that, through the protection and reinforcement layer, it not only comprises a more uniform structure (compared to the known panels), but also has excellent mechanical strength.

In particular, the lamina in glass fiber gives rigidity to the structure; the same rigidity that, otherwise, is delegated only to the mechanical characteristics of the sheet-like element. It allows the realization of different embodiments that may also avoid the use of a metal laminate or even less of the sheet-like element itself, with significant economic benefits.

Another advantage of the invention is given by the consolidation sheet in glass fiber that counteracts the possible rupture of the solar cells due to incorrect handling operations, a careless assembling and/or mounting or particular environmental conditions.

Furthermore, the front layer upper face rusticating makes the surface non-slip, which facilitates movements of workers on the top surface.

Another advantage of the invention is due to the fact that the particularity of EVA consists of it undergoing an irreversible chemical transformation that makes it stable over time. For this reason, the Ethylene-Vinyl Acetate layer, interposed between the lower surface of the flexible sheet and the sheet-like element, allows it to indissolubly associate the overlying strata and to be made from a wide range of materials with which the sheet-like element may be composed, so that the user can select the type of panel that best suits his needs and the structural characteristics of the location where the photovoltaic module will be installed.

Moreover, the employment of means easily available commercially and the usage of common materials make the device economically competitive.

Although the disclosed embodiments have been fully described with reference to the accompanying drawings, it is to be noted that various changes and modifications will become apparent to those skilled in the art. Such changes and modifications are to be understood as being included within the scope of the disclosed embodiments as defined by the appended claims.

All the details may further be replaced by other technically equivalent elements.

In practice, the materials used, as well as the dimensions, may be any, according to requirements.

The disclosure in Italian Patent Applications No. AR2011U000010 and No. AR2012U00008 from which this application claims priority are incorporated herein by reference.

Where technical features mentioned in any claim are followed by reference numbers, those reference numbers have been included for the sole purpose of increasing the intelligibility of the claims and accordingly, such reference numbers do not have any limiting effect on the interpretation of each element identified by way of example by such reference numbers.

## Claims

1. A photovoltaic module for the generation of electricity, particularly for the top surface covering of residential and industrial buildings, caravans, recreational vehicles and boats, comprising:
- a front sheet (2) on outer position with respect to the top surface covering (9) of a building, in a transparent material and associated with at least a first plastic copolymer layer (3);
- a photovoltaic sheet (5) interposed between said first plastic copolymer layer (3) and a second plastic copolymer layer (6);
- a flexible sheet (7) associated to said second plastic copolymer layer (6).

2. The photovoltaic module according to the previous claim, wherein said front sheet (2) comprises a rusticated external surface, so as to be slip-resistant.

3. The photovoltaic module according to the previous claim, wherein said front sheet (2) comprises a polymer chain which comprises ethylene tetrafluoroethylene.

4. The photovoltaic module according to the previous claim, wherein said front sheet (2) consists of one polyester film (21b) coated with a top film (22'b) and a low film (22"b) in polyvinylidene fluoride.

5. The photovoltaic module according to one or more of the previous claims, wherein said at least a first plastic copolymer layer (3) comprises an upper face and a lower face, said upper face being associated with said front sheet (2) and said lower face being associated with at least one protection and reinforcement layer (4).

6. The photovoltaic module according to one or more of the previous claims, wherein said at least one protection and reinforcement layer (4) comprises at least one additional plastic copolymer layer (10) for improving the adhesion of beneath layers.

7. The photovoltaic module according to one or more of the previous claims, wherein said at least one protection and reinforcement layer (4) comprises at least one polyester film (11) encapsulated between two coating films (12', 12") in polyvinylidene fluoride for improving the protection for said photovoltaic sheet (5) and for affording an adequate rigidity to the photovoltaic module.

8. The photovoltaic module according to one or more of the previous claims, wherein said at least one protection and reinforcement layer (4) comprises a first lamina (13) in glass fiber, for increasing the mechanical characteristics and improving the foot traffic resistance of the photovoltaic module.

9. The photovoltaic module according to one or more of the previous claims, **characterized by** the fact to comprise a consolidation sheet (16) in glass fiber, which is interposed between said photovoltaic sheet (5) and said second plastic copolymer layer (6), for counteracting the possible damage.

10. The photovoltaic module according to one or more of the previous claims, **characterized by** the fact ta comprise at least one sheet-like element (8) which is connected to said flexible sheet (7) by means of association and is arranged to be bound at the top surface covering (9).

11. The photovoltaic module according to one or more of the previous claims, wherein said sheet-like element (8) comprises an Ethylene-Vinyl Acetate layer (15) which is interposed between the lower surface of said flexible sheet (7) and the upper surface of said sheet-like element (8) for bonding said flexible sheet (7) and said sheet-like element (8).

12. The photovoltaic module according to one or more of the previous claims, wherein said sheet-like element (8) is a laminate metal alloy.

13. The photovoltaic module according to one or more of the previous claims, wherein said sheet-like element (8) is in fiberglass.

14. The photovoltaic module according to one or more of the previous claims, wherein said sheet-like element (8) is in composite fiber-reinforced material.

15. The photovoltaic module according to one or more of the previous claims, wherein said sheet-like element (8) consists of a polyester film (21') coated by polyvinylidene fluoride films (22', 22").
